Europäisches Patentamt

European Patent Office

Office européen des brevets

(11) Veröffentlichungsnummer: **0 094 559**

**B1**

(12) **EUROPÄISCHE PATENTSCHRIFT**

(45) Veröffentlichungstag der Patentschrift: **02.03.88**

(21) Anmeldenummer: **83104402.9**

(22) Anmeldetag: **04.05.83**

(51) Int. Cl.⁴: **H 01 L 21/82,** H 01 L 21/90, H 01 L 21/306

(54) Verfahren zum Herstellen von integrierten MOS-Feldeffekttransistoren mit einer aus Metallsiliziden bestehenden zusätzlichen Leiterbahnebene.

(30) Priorität: **14.05.82 DE 3218309**

(43) Veröffentlichungstag der Anmeldung:
**23.11.83 Patentblatt 83/47**

(45) Bekanntmachung des Hinweises auf die
Patenterteilung:
**02.03.88 Patentblatt 88/09**

(84) Benannte Vertragsstaaten:
**AT DE FR GB IT SE**

(56) Entgegenhaltungen:
**EP-A-0 072 522**
**DE-A-2 738 493**
**DE-A-2 949 198**
**DE-A-3 027 954**
**US-A-4 052 253**
**US-A-4 102 733**

**JAPANESE JOURNAL OF APPLIED PHYSICS,
Band 18, Ergänzungsband 18-1, 1979, Tokio H.
SUNAMI et al. "Selective oxide coating of
silicon gate (SELOCS)", Seiten 255-260**

(73) Patentinhaber: **Siemens Aktiengesellschaft
Berlin und München
Wittelsbacherplatz 2
D-8000 München 2 (DE)**

(72) Erfinder: **Neppl, Franz, Dr.
St. Quirin-Platz 6
D-8000 München 90 (DE)**
Erfinder: **Schwabe, Ulrich, Dr.
Grünwalder Strasse 40
D-8000 München 90 (DE)**

Courier Press, Leamington Spa, England.

**Bescreibung**

Die Erfindung betrifft ein Verfahren zum Herstellen von integrierten MOS-Feldeffekttransistoren, insbesondere von komplementären MOS-Feldeffekttransistorschaltungen (CMOS-FETs), bei dem als zusätzliche Leiterbahnebene eine aus hochschmelzenden Metallsiliziden, wie Siliziden von Molybdän, Wolfram, Tantal oder Titan bestehende Schichtstruktur verwendet wird, und bei dem als Zwischenoxid zwischen der Metallsilizidebene und der Metall-Leiterbahnebene eine phosphorhaltige Siliziumoxidschicht verwendet wird.

Mit abnehmenden Strukturgrößen bei integrierten Schaltungen wird die Packungsdichte in steigendem Maße durch Verdrahtungsraster und der Art der möglichen Kontakte bestimmt.

Durch die Verwendung einer zweiten Metallverdrahtungsebene oder einer Silizidverdrahtungsebene, wie in DE—A—30 27 954 beschrieben, wird bei integrierten Schaltungen eine Erhöhung der Packungsdichte möglich. Letztere ist wegen ihres im Vergleich zur zweiten Metallverdrahtungsebene kleineren Rasters und der größeren Kontaktierungsmöglichkeiten vor allem zur Platzeinsparung innerhalb einzelner Gatter geeignet.

Eine weitere Erhöhung der Packungsdichte ist durch überlappende Kontakte gegeben (siehe V. L. Rideout, IBM Technical Disclosure Bulletin, Vol. 17, No. 9, 2802, 1975). Überlappende Kontakte auf $n^+$-Silizium sind wegen der Gefahr von Substrat-Kurzschlüssen an der Kante der durch thermische Oxidation auf dem Substrat erzeugten Feldoxidbereiche problematisch. Außerdem erfordern zusätzliche Verdrahtungsebenen im allgemeinen zwei zusätzliche Fotolithographieprozesse und erhöhen damit die Defektdichte.

Ein Verfahren mit Silizidpilzkontakten ist bereits in EP—A—0 072 522, veröffentlicht am 23.2.1983, vorgeschlagen worden. Bei diesem Verfahren werden Kontaktlöcher erzielt, die wenig Unterätzung aufweisen. Durch die als Zwischenoxid dienende Phosphorglasschicht können beim Verfließenlassen wegen der Silizidzwischenschicht (Pilz) in den Kontakten die Kontaktlöcher verrundet werden, ohne daß die $p^+$-Bereiche der Schaltung freiliegen.

Die Aufgabe, die der vorliegenden Erfindung zugrundeliegt, besteht nun darin, die Vorteile der Verwendung einer Silizidverdrahtungsebene und von Silizidpilzkontakten mit den Vorteilen der Anwendung von überlappenden Kontakten zu kombinieren und dadurch die Packungsdichte einer integrierten Schaltung noch weiter zu erhöhen. Es ist weiterhin Aufgabe der Erfindung, die Erzeugung der überlappenden Kontakte unter Verwendung der Silizidverdrahtungsebene in einem Herstellungsprozeß für MOS-Schaltungen mit möglichst geringem technologischen Mehraufwand durchzuführen.

Diese Aufgabe wird bei einem Verfahren der eingangs genannten Art durch den Ablauf der folgenden Verfahrensschritte gelöst:

a) ganzflächiges Abätzen der Oxidschicht über den durch Ionenimplantation erzeugten dotierten Bereichen des die dotierte, strukturierte Polysiliziumgateelektrode, sowie die die aktiven Bereiche trennenden Feldoxidbereiche des MOS-Feldeffekttransistors enthaltenden Substrats,

b) ganzflächige Abscheidung einer Phosphor enthaltenden SiO$_2$-Schicht,

c) Einbringen der Kontaktlöcher in die Phosphorglasschicht für die zusätzliche, aus Silizid bestehende Leiterbahnebene sowohl zu den dotierten Polysiliziumbereichen als auch zu den durch Ionenimplantation erzeugten aktiven Bereichen mit einem Ätzmittel, das eine hohe Selektivität von Phosphorglas zu SiO$_2$ aufweist, wodurch die später erzeugten Kontakte zu den aktiven Bereichen überlappend über die Feldoxidkante ausgebildet sind,

d) Abscheidung einer Metallsilizidschicht und Strukturierung der Silizidschicht so, daß über allen Kontaktlöchern ein großer Silizidfleck (Pilz) entsteht,

e) Abscheidung einer weiteren, als Isolationsschicht dienenden Phosphorglasschicht,

f) Einbringen der Kontaktlöcher in die zweite Isolationsschicht für die Kontakte der äußeren Leiterbahnebene zur Silizid-Leiterbahnebene und

g) Herstellen der äußeren Leiterbahnebene.

Dabei liegt es im Rahmen der Erfindung, daß die Phosphor enthaltende SiO$_2$-Schicht aus der Gasphase bei einem Druck von kleiner 100 Pa und einer Temperatur im Bereich von 300 bis 500°C erzeugt wird (sogenanntes low-pressure-lowtemperature-oxid) und als Ätzgemisch für die Kontaktlochätzung ein Flußsäure (HF, 49%) Ammonfluorid (NH$_4$F, 40%)-Gemisch verwendet wird.

In einer Weiterbildung des Erfindungsgedankens ist vorgesehen, daß die SiO$_2$-Schicht einen Phosphorgehalt von kleiner 8% aufweist und die Ätzmischung aus einem HF/NH$_4$-Ätzgemisch mit einem Mischungsverhältnis von 7:1 besteht.

Bei dem Verfahren nach der Lehre der Erfindung werden durch diese Isolationsschicht die die Feldoxidbereichs (LOCOS)- bzw. Polysiliziumkanten überlappenden Kontaktlöcher geätzt. Voraussetzung für zuverlässiges Vermeiden der Substratkurzschlüsse ist dabei die Kombination aus Isolationsschicht und Ätzmittel mit einer möglichst hohen Selektivität des Ätzmittels zum thermischen SiO$_2$ (Feldoxid) bzw. Silizium, wie es für phosphorhaltiges, bei niedrigem Druck und niedriger Temperatur erzeugten SiO$_2$ und einer HF/NH$_4$F 7:1 SiO$_2$-Ätze der Fall ist.

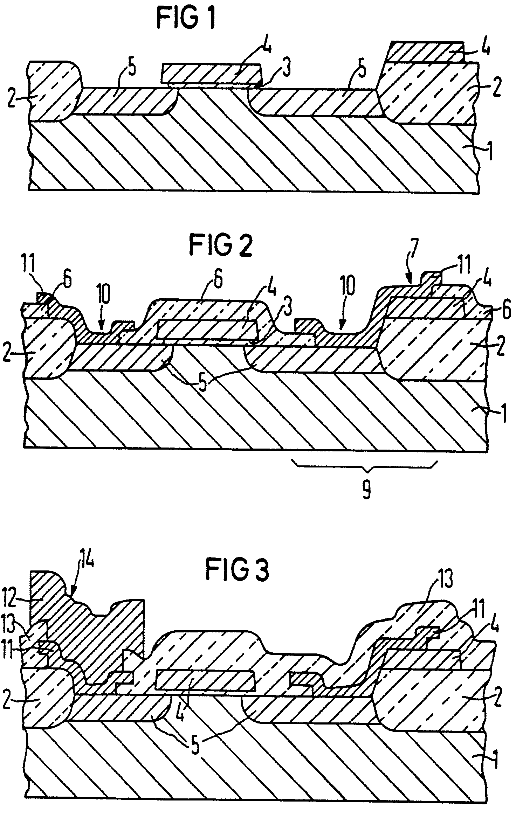

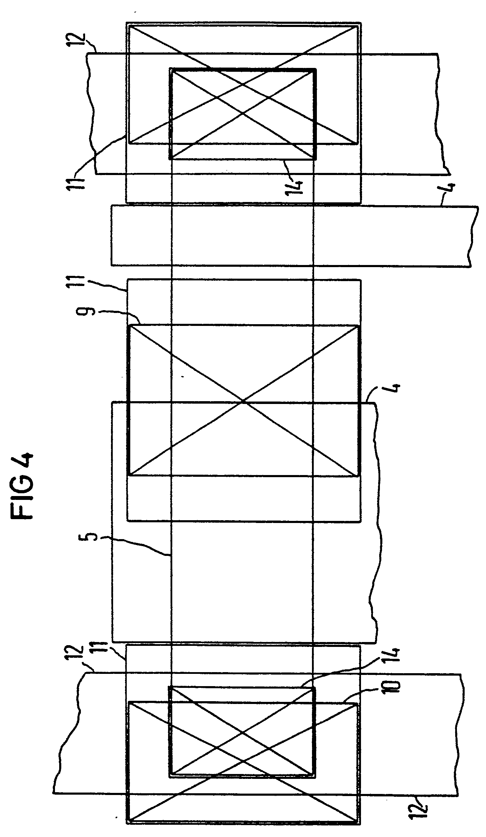

Anhand eines Ausführungsbeispiels und der Figuren 1 bis 3, welche im Schnittbild die beim Verfahren in den verschiedenen Stadien entstehenden erfindungswesentlichen Strukturen schematisch darstellen, wird im folgenden die Erfindung für einen n-Kanal-MOS-Transistor noch näher erläutert. Die Figur 4 zeigt als Layout in einem Anwendungsbeispiel einen N-MOS-Inverter mit überlappendem Kontakt und Silizid.

*Figur 1:* Für die Herstellung eines n-Kanal-MOS-Feldeffekttransistors wird folgendermaßen vorgegangen: Auf einem einkristallinen, p-dotierten (100)-orientierten Siliziumsubstrat 1 mit einem spezifischen Widerstand im Bereich von 2 bis 50 Ohm cm werden mit Hilfe der bekannten LOCOS-Technik nach erfolgter Feldimplantation Feldoxidbereiche 2 ($d_{ox} = 700$ nm) und aktive Bereich (ohne Oxid) definiert. Durch Aufoxidation wird in den aktiven Bereichen das Gateoxid 3 mit 40 nm Schichtdicke erzeugt. Darauf wird durch einen CVD-Prozeß (= chemical vapor deposition) ganzflächig eine 500 nm dicke Polysiliziumschicht 4 abgeschieden, $n^+$ dotiert und strukturiert. Es folgt eine Arsen-Ionenimplantation zur Erzeugung der $n^+$-dotierten Bereiche 5. Nun erfolgt der erste erfindungswesentliche Schritt, bei dem das auf dem Substrat vorhandene Oxid in einer Schichtdicke von 40 nm ganzflächig entfernt wird. Dabei entsteht das in Figur 1 dargestellte Schnittbild.

*Figur 2:* Die gesamte Anordnung wird nun mit einer 4% Phosphor enthaltenden $SiO_2$-Schicht 6 in einer Schichtdicke von 500 nm versehen. Diese Schicht 6 wird erzeugt bei einer Temperatur von 430°C und einem Druck von 27 Pa (LTO-Abscheidung) aus der Gasphase. In dieses Isolationsoxid 6 werden nun sowohl die Kontakte für die zusätzliche, vorzugsweise aus Tantalsilizid bestehende Ebene 11 für die Tantalsilizid-Polysiliziumebene 7, Tantalsilizid-$n^+$-Bereiche 10, als auch die Pilz-Kontakte für die aus Aluminium/Silizium bestehende Leiterbahnebene (12) zu den Poly-Si- und $n^+$-Bereichen geöffnet. Bei dieser Kontaktlochätzung wird ein weiterer erfindungswesentlicher Schritt durch eine selektive Ätzung mit einem, beispielsweise aus HF (49%)-$NH_4F$ (40%)-Ätzgemisch im Mischungsverhältnis 7:1 angewandt, wobei sich ein Ätzratenverhältnis zum thermischen Oxid (2) von 3 bis 7 einstellt, das heißt, die phosphorhaltige $SiO_2$-Schicht wird bei 8% Phosphorgehalt um den Faktor 7 schneller geätzt als das thermische Oxid (Feldoxid 2). Nach erfolgter erster Kontaktlochätzung (7, 10) wird die aus Tantalsilizid bestehende zweite Leiterbahnebene 11 in einer Schichtdicke von 200 bis 500 nm niedergeschlagen und so strukturiert, daß über allen Kontakten (7, 10) ein übergroßer Tantalsilizidfleck (Pilz) verbleibt. Die Strukturierung ist aus Figur 2 ersichtlich. Der mit der Klammer 9 gekennzeichnete Bereich umfaßt den durch das Verfahren nach der Lehre der Erfindung erzielten "buried contact"-Ersatz. Wie aus Figur 2 ersichtlich ist, ergibt sich durch den erfindungsgemäßen überlappenden Kontakt eine deutliche Platzersparnis.

*Figur 3:* Es wird nun das aus Phosphorsilikatglas bestehende Zwischenoxid aus der Gasphase (LTO-Abscheidung) mit einem Phosphorgehalt von 4% in einer Schichtdicke im Bereich von 500 bis 1500 nm abgeschieden und die zweite Kontaktlochätzung für die Kontakte 14 der Aluminium/Silizium-Leiterbahnebene 12 zur Tantalsilizidebene 11 durchgeführt. Im Anschluß daran erfolgt das Verfließenlassen der Phosphorglasschicht zum Abrunden der Kontaktlochbereiche, wobei jetzt die $p^+$-Bereiche des p-Kanal-Transistors einer CMOS-Schaltung durch die über ihnen liegenden Teile der Tantalsilizidschicht 11 maskiert werden. Diese Strukturierung ist in der Figur 3 nicht dargestellt; nähere Einzelheiten sind aus der Patentanmeldung P 30 27 954 zu entnehmen. Die gesamte aus Gateoxid 3, Isolationsoxid 6 und aus dem Zwischenoxid bestehende Oxidschicht wird der besseren Übersicht wegen in Figur 3 mit den Bezugszeichen 13 bezeichnet. Abschließend wird in bekannter Weise die aus Aluminium/Silizium bestehende Leiterbahnebene 12 erzeugt.

Bei dieser Prozeßführung ergibt sich neben den generellen Vorteilen einer zweiten Verdrahtungsebene ein im Vergleich zum sonst üblichen "buried contact" platzsparender Kontakt Polysilizium/Diffusion (siehe Figur 2).

Durch die Siliziumverbindung sind insbesondere Kontakte aus der Polysilizium-Ebene nicht nur zu $n^+$-Silizium sondern auch zu $p^+$-Silizium möglich. Dies eröffnet neue Möglichkeiten beim CMOS-Design. Da die "buried contact"-Maske eingespart werden kann, erfordert die zusätzliche Verdrahtungsebene höchstens einen zusätzlichen Fotolithographieschritt. Bei CMOS-Prozessen mit "buried contact" und "switched capacitor" ist kein zusätzlicher Fotolithographisschritt nötig, da das Silizid gleichzeitig als Elektrode des switches capacitor" benützt werden kann. Damit ist eine Erhöhung der Packungsdichte und der Vorteil einer zweiten unabhängigen Verdrahtung mit relativ geringen technologischen Mehraufwand gegeben.

*Figur 4* zeigt als Anwendungsbeispiel das Layout im Maßstab 1000:1 eines NMOS-Inverters. Dabei sind die gleichen Bezugszeichen verwendet wie in den Figur 1 bis 3.

Die Vorteile des Layouts nach der Lehre der Erfindung liegen in den beiden platzsparenden überlappenden Silizidpilzkontakten links und rechts (10, 11, 12, 14), sowie im neuen Poly-Si/Diffusionskontakt (4, 9, 11, 5), der platzsparend zwischen die beiden Gates gelegt werden kann, ohne daß der selbstjustierende Charakter des Depletions-Transistors (linker Bereich 4) verlorengeht.

**Patentansprüche**

1. Verfahren zum Herstellen von integrierten MOS-Feldeffekttransistoren, insbesondere von komplementären MOS-Feldeffekttransistorschaltungen (CMOS-FETs), bei dem als zusätzliche Leiterbahnebene eine aus hochschmelzenden Metallsiliziden, wie Siliziden von Molybdän, Wolfram, Tantal oder Titan bestehende Schichtstruktur verwendet wird, und bei dem als Zwischenoxid zwischen der Metallsilizidebene und der Metall-Leiterbahnebene eine Phosphoraltige Siliziumoxidschicht verwendet wird, gekennzeichnet durch den Ablauf der folgenden Verfahrensschritte:

a) ganzflächiges Abätzen der Oxidschicht (3) über den durch Ionenimplantation erzeugten dotierten Bereichen (5) des die dotierte, strukturierte Polysiliziumgateelektrode (4), sowie die die aktiven Bereiche (5) trennenden Feldoxidbereiche (2) des MOS-Feldefekttransistors enthaltenden Substrats (1),

b) ganzflächige Abscheidung einer Phosphor enthaltenden SiO₂-Schicht (6),

c) Einbringen der Kontaktlöcher (7, 10) in die Phosphorglasschicht (6) für die zusätzliche, aus Silizid bestehende Leiterbahnebene (11) sowohl zu den dotierten Polysiliziumbereichen (4) als auch zu den durch Ionenimplantation erzeugten aktiven Bereichen (5) mit einem Ätzmittel, das eine hohe Selektivität von Phosphorglas zu SiO₂ aufweist, wodurch die später erzeugten Kontakte (14) zu den aktiven Bereichen (5) überlappend über die Feldoxidkante (2) ausgebildet sind.

d) Abscheidung einer Metallsilizidschicht und Strukturierung der Silizidschicht (11) so, daß über allen Kontaktlöchern (7, 10) ein großer Silizidfleck (Pilz) entsteht,

e) Abscheidung einer weiteren, als Isolationsschicht dienenden Phosphorglasschicht (13),

f) Einbringen der Kontaktlöcher (14) in die zweite Isolationsschicht (13) für die Kontakte der äußeren Leiterbahnebene (12) zur Silizid-Leiterbahnebene (11) und

g) Herstellen der äußeren Leiterbahnebene (12).

2. Verfahren nach Anspruch 1, dadurch gekennzeichnet, daß die Phosphor enthaltende SiO₂-Schicht (6) aus der Gasphase bei einem Druck von kleiner 100 Pa und einer Temperatur im Bereich von 300 bis 500°C erzeugt wird und daß als Ätzgemisch für die Kontaktlochätzung (7, 10) ein Flußsäure (49%)-Ammonfluorid (40%)-Gemisch verwendet wird.

3. Verfahren nach Anspruch 2, dadurch gekennzeichnet, daß die SiO₂-Schicht (6) einen Phosphorgehalt bis zu 8% aufweist und die Ätzmischung aus einem HF/NH₄F-Ätzgemisch mit einem Mischungsverhältnis von 7:1 besteht.

4. Verfahren nach Anspruch 1 bis 3, dadurch gekennzeichnet, daß die Dicke der SiO₂-Schicht (6) auf einen Bereich von 50 bis 500 nm eingestellt wird.

5. Verfahren nach Anspruch 1 bis 4, dadurch gekennzeichnet, daß als Metallsilizidschicht (11) eine Tantalsilizidschicht in einer Schichtdicke von 200 bis 500 nm verwendet wird.

**Revendications**

1. Procédé pour fabriquer des transistors à effet de champ MOS intégrés, en particulier de circuits à transistors à effet de champ MOS complémentaires (CMOS-FETs), selon lequel on utilise, en tant que plan supplémentaire de pistes conductives, une structure de couche constituée de siliciures métalliques à haut point de fusion, tels que des siliciures de molybdène, tungstène, tantale ou titane, et selon lequel on utilise une couche d'oxyde de silicium contenant du phosphore en tant qu'oxyde intermédiaire entre le plan de siliciure métallique et le plan de pistes conductives métalliques, caractérisé par les étapes suivantes:

a) l'enlèvement par gravure sur toute la surface de la couche d'oxyde (3) au-dessus des zones dopées (5), formées par implantation d'ions, du substrat (1) contenant l'électrode de grille (4) de polysilicium, dopée et structurée, de même que les zones (2) d'oxyde de champ, contenant le transistor à effet de champ MOS, séparant les zones actives (5),

b) le dépôt sur toute la surface d'une couche de SiO₂ (6) contenant du phosphore,

c) la formation des trous de contact (7, 10) dans la couche de verre phosphoré (6) pour le plan (11) de pistes conductives supplémentaire, de siliciure, trous qui mènent à la fois aux zones (4) de polysilicium dopées et aux zones actives (5) formées par implantation d'ions, au moyen d'un agent de gravure qui présente une haute sélectivité pour le verre phosphoré par rapport au SiO₂, de sorte que les contacts (14), réalisés ultérieurement et menant aux zones actives (5), sont formés à recouvrement sur le bord (2) de l'oxyde de champ,

d) le dépôt d'une couche de siliciure métallique et sa structuration de cette couche de siliciure (11) de manière qu'une grande tache (champignon) de siliciure se forme au-dessus de tous les trous de contact (7, 10),

e) le dépôt d'une couche supplémentaire (13) de verre phosphoré, servant de couche isolante,

f) la formation des trous de contact (14) dans la seconde couche isolante (13) pour les contacts du plan extérieur (12) de pistes conductives, menant au plan (11) de pistes conductives en siliciure et

g) la réalisation du plan extérieur (12) de pistes conductives.

2. Procédé selon la revendication 1, caractérisé en ce que la couche de SiO₂ (6), contenant du phosphore, est formée à partir de la phase gazeuse sous une pression inférieure à 100 Pa et une température comprise entre 300 et 500°C et que l'on utilise pour la gravure des trous de contact (7, 10) un mélange de gravure formé d'acide fluorhydrique (49%) et de fluorore d'ammonium (40%).

3. Procédé selon la revendication 2, caractérisé en ce que la couche de SiO₂ (6) présente une teneur en phosphore pouvant atteindre 8% et que le mélange de gravure est un mélange de HF/NH₄F ayant un rapport de mélange de 7:1.

4. Procédé selon les revendications 1 à 3, caractérisé en ce que l'épaisseur de la couche de SiO₂ (6) est réglée entre 50 et 500nm.

5. Procédé selon les revendications 1 à 4, caractérisé en ce que l'on utilise une couche de siliciure de tantale d'une épaisseur de 200 à 500 nm en tant que couche (11) de siliciure métallique.

**Claims**

1. A process for the production of integrated MOS field effect transistors, particularly but not exclusively complementary MOS field effect transistor circuits (CMOC-FETs), in which a layer structure consisting of high-melting point metal silicides, such as silicides of molybdenum, tungsten, tantalum, or titanium, is used as an additional conductor path level, and in which a layer of silicon oxide containing phosphorus is used as intermediate oxide between the metal silicide level and the metal conductor path level, characterised by the sequence of the following process steps:

a) etching away of the oxide layer (3) from the entire surface above the doped zones (5) produced by ion implantation, of the substrate (1) which contains the doped, structured polysilicon gate electrode (4) and the field oxide zones (2), which separate the active zones (5) of the MOS field effect transistor,

b) deposition of a $SiO_2$-layer (6) containing phosphorus, on to the entire surface,

c) introduction of the contact holes (7, 10) into the phosphorus-glass layer (6) for the additional conductor path level (11) which consists of silicide, both to the doped polysilicon zones (4) and to the active zones (5) produced by ion implantation, using an etching agent which has a high selectivity for phosphorous-glass as compared with $SiO_2$, whereby the contacts (14) to the active zones (5) subsequently produced, are formed so as to overlap the field oxide edge (2),

d) deposition of a metal silicide layer and structuring of the silicide layer (11) in such manner that a large silicide patch (mushroom) is formed above all the contact holes (7, 10),

e) deposition of a further phosphorus-glass layer (13) which serves as insulating layer,

f) introduction of the contact holes (14) into the second insulating layer (13) for the contacts of the outer conductor path level (12) to the silicide conductor path level (11), and

g) formation of the outer conductor path level (12).

2. A process as claimed in Claim 1, characterised in that the phosphorus-containing $SiO_2$-layer (6) is produced from the gas phase at a pressure of less than 100 Pa and at a temperature in the range of between 300 and 500°C; and that a hydrofluoric acid (49%)-ammonium fluoride (40%) mixture is used as etching mixture for the contact hole etching (7, 10).

3. A process as claimed in Claim 2, characterised in that the $SiO_2$-layer (6) has a phosphorus content of up to 8% and the etching mixture consists of a $HF/NH_4F$-etching mixture in a mixing ratio of 7:1.

4. A process as claimed in Claim 1 to 3, characterised in that the thickness of the $SiO_2$-layer (6) is set within a range of 50 to 500 nm.

5. A process as claimed in Claim 1 to 4, characterised in that a tantalum silicide layer of thickness 200 to 500 nm is used as metal silicide layer (11).

# FIG 1

# FIG 2

# FIG 3

1

# FIG 4

0 094 559